Europäisches Patentamt

European Patent Office

Office européen des brevets

(11) Publication number: **0 240 864**
A2

## (12) EUROPEAN PATENT APPLICATION

(21) Application number: 87104534.0

(22) Date of filing: 27.03.87

(51) Int. Cl.³: **G 06 F 11/00**

(30) Priority: 03.04.86 US 847411

(43) Date of publication of application:
14.10.87 Bulletin 87/42

(84) Designated Contracting States:
DE FR GB

(71) Applicant: HEWLETT PACKARD COMPANY
Legal Department 3000 Hanover Street
Palo Alto, CA 94304(US)

(72) Inventor: Keshner, Marvin S.
321 Easy Street, Nr. 2
Mountain View, CA. 94043(US)

(72) Inventor: Eaton, Steven Glen
1755 Ednamary Way, Nr. 4
Mountain View, CA. 94040(US)

(74) Representative: Liesegang, Roland, Dr.-Ing.
BOEHMERT & BOEHMERT Widenmayerstrasse 4
Postfach 22 01 37
D-8000 München 22(DE)

(54) High-yield semiconductor memory devices.

(57) Memory devices consist of small memory blocks memory (12) with very high yields (approximately 97%). Each block (12) is capable of functioning whether or not neighboring blocks are defective. Blocks are interconnected with only five lines and communicate serially. External circuitry (42) contains ECC, a means for avoiding defective blocks and using spares, plus interface and control circuitry.

FIG 1B

0240864

**Dr.-Ing. Roland Liesegang**

Patentanwalt
European Patent Attorney

Sckellstrasse 1
D-8000 München 80

Telefon (089) 4482496
Telefax (089) 4480433
Telex 5214382 pali d

HEWLETT-PACKARD COMPANY

Palo Alto, USA

EU 012 65

## High-Yield Semiconductor Memory Devices

For decades there has been a continuing need for faster, cheaper, and more reliable computer memory. Among the various technologies available for storing data, the development of semiconductor technology for this purpose has been astounding. However, several obstacles prevent semiconductory memory from competing with magnetic data storage in terms of price, error rates, and non-volatility.

In order to reduce the price of semiconductor memory, the yields must remain high as the chip size increases. However, as the chip size increases, the probability of defects increase. In semiconductor memory chips with areas of 1 square cm., on average, each chip has one or more defects. One attempt to improve yields of large chips replaces defective memory cells with redundant rows and columns. In another attempt to improve yields of large chips, memory management circuitry detects bad bits and replaces them with good bits on another chip. However, these schemes produce moderate results. There are only moderate yields of good die in the first scheme and only a moderate fraction of the available good bits are utilized in the second scheme. Thus, as chip size increases the useable memory per unit area of silicon process decreases, resulting in higher memory cost.

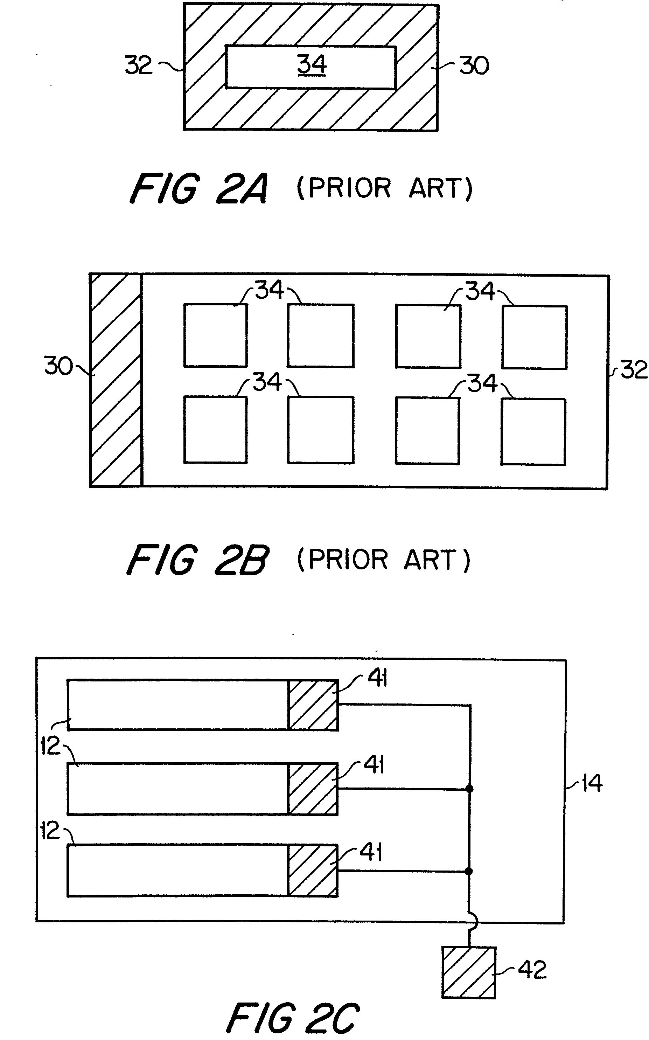

In addition, the schemes discussed above cannot rectify failures of the control circuitry located on the chip. Control circuitry such as address decoders, interfaces and drivers can malfunction. Control circuitry 30 of the prior art is shown in Figure 2A and 2B. Control circuitry 30 of the prior art interfaces with all memory blocks 34 on the chip 32. One failure of the control circuitry 30 can render the entire chip useless.

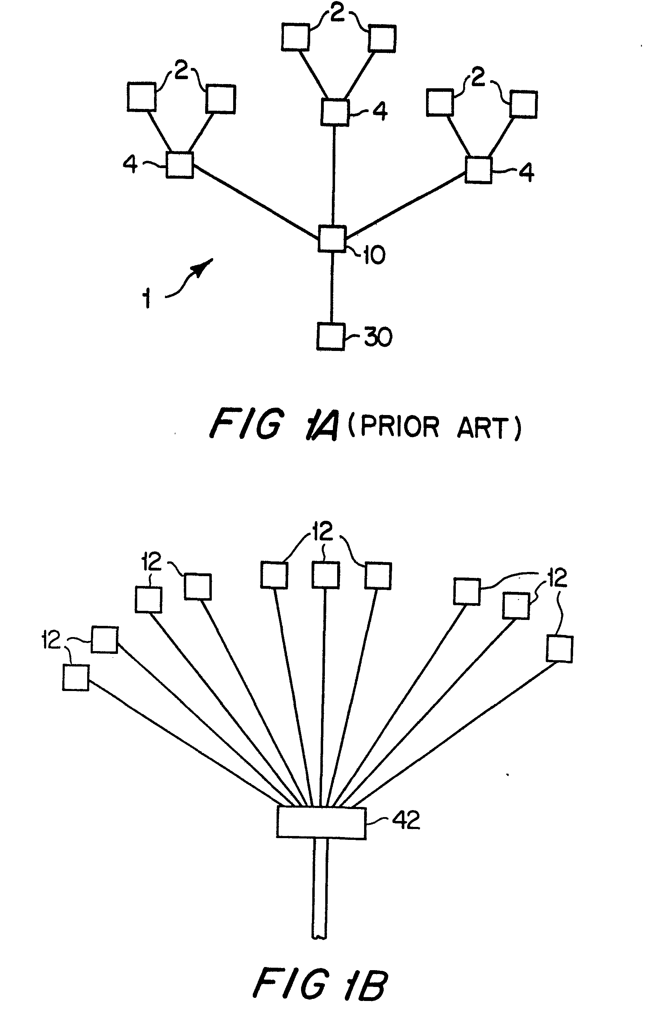

There is a third prior art scheme for interconnecting memory blocks 2, 4, and 10 as shown in Figure 1 which can magnify the impact of a defect. In it, the third-layer memory blocks 2 connect through second-layer memory blocks 4. If a second-layer memory block 4 fails, then the third-layer memory blocks 2 are inaccessible. Likewise, if a primary-layer memory block 10 fails, then all third-layer memory blocks 2 and second-layer memory blocks 4 are inaccessible. Thus, the failure of one memory block can render large portions of memory useless.

The preferred embodiment of the invention is a high-yield memory device 14 that it is much faster than mechanical disks, and much cheaper than DRAM. As semiconductor technology advances, the present invention will maintain its low price per bit advantage over DRAM by adopting the same advances in semiconductor technology that DRAM adopts. The invention obtains high-yield memory by solving several problems of the prior art.

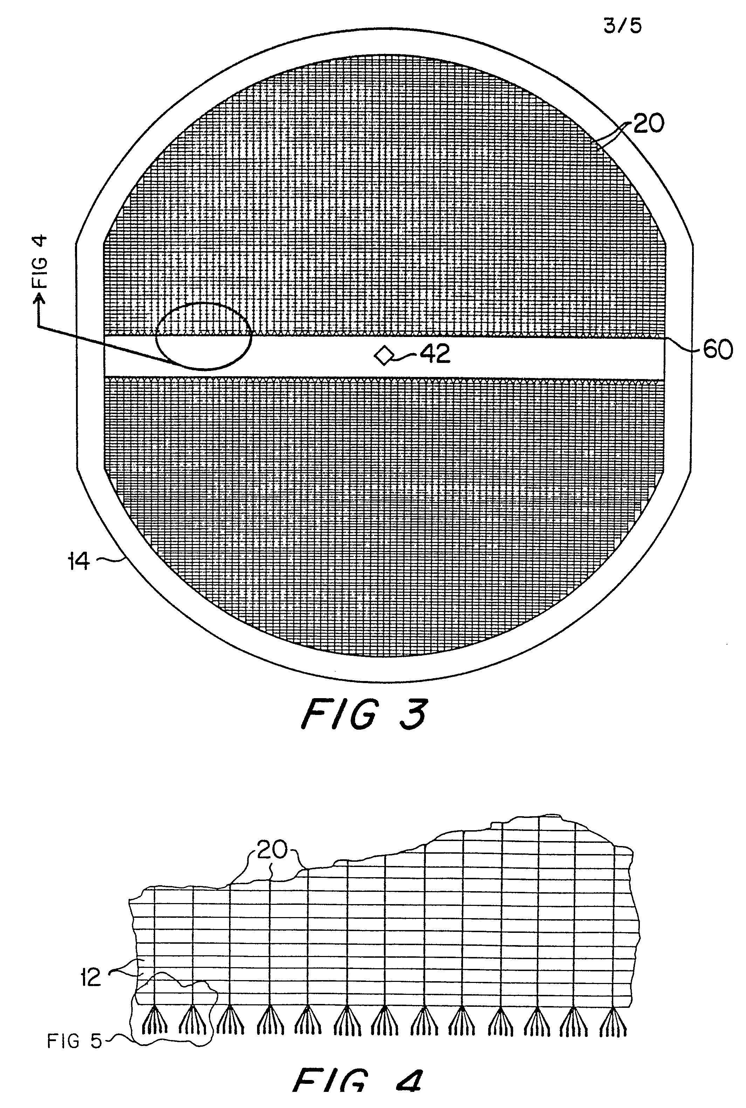

To isolate the affects of defects on the memory device 14, memory cells are grouped into small memory blocks 12, as shown in Figure 3, 4, 5, and 6. Because of their small size, the yield of memory blocks 12 is greater than 97%. The memory blocks 12 are designed to function independently and identically to each other. Therefore, a defect on one memory block 12 does not affect other memory blocks 12. If one memory block 12 malfunctions, another identical memory block 12 can be substituted for the malfunctioning memory block 12. Thus, even though the number of defects per memory device 14 remains unchanged from the prior art, the amount of useable memory is greatly increased. As a result, the yield of the memory device 14 is nearly 100% and its average percentage of useable bits is greater than 90%. These greatly enhanced yields result in lower memory cost.

In the early prior art DRAM memory devices 32, shown in Figure 2A, the control circuitry 30 controls one memory block 34. As the technology progressed to permit more bits per chips, the memory was divided into blocks 34, shown in Figure 2B, and all the control circuitry 30 continued to control all the memory blocks 34. The present invention, for the purpose of enhanced yield discussed above, divided

3

the control circuitry 30 into two parts. The first part, called memory block control circuitry (MBCC) 41, is duplicated for each memory block 12. Thus, each MBCC 41 is dedicated to one memory block 12 and permits each memory block 12 to function independently of every other memory block 12. The second part of the control circuitry 42, called memory device control circuitry (MDCC) 42, connects to every MBCC 41 on the memory device 14.

The MDCC 42 includes error correction circuitry, error logging circuitry, interface circuitry, and line driver circuitry. The present invention manufactures the memory device control circuitry (MDCC) 42 on a separate substrate. After manufacture, the MDCC 42 is tested and then attached to numerous MBCC 41 on the memory device 14. In the preferred embodiment of the invention, there will be one MDCC 42 per one or more memory devices 14. It will control all the MBCC 41 and their corresponding memory blocks 12 on each memory device 14. If an MDCC 42 malfunctions while attached to MBCC 41, it can be replaced.

The connecting scheme presented in Figure 1B, promotes higher-yield memory devices 14. Instead of connecting memory blocks in a tree-like structure to the control circuitry 30, as the prior art does in Figure 1A, the present invention connects each memory block 12 and its MBCC 41 directly to MDCC 42, as shown in Figure 1B.

4

Therefore, if one memory block 12 in the preferred embodiment of the invention malfunctions, it will not affect the performance of any other memory block 12.

## Brief Description of the Drawings

Figure 1A shows the prior art interconnection of memory blocks.

Figure 1B shows how the preferred embodiment of the invention interconnects memory blocks.

Figure 2A shows the early prior art distribution of control circuitry.

Figure 2B shows recent prior art distribution of control circuitry.

Figure 2C shows how the preferred embodiment of the invention distributes control circuitry.

Figure 3 is an actual size drawing of the preferred embodiment of the invention.

Figure 4 is a designated portion of Figure 3 magnified four times which shows individual memory blocks and buses.

Figure 5 is a designated portion of Figure 4 magnified eight times which shows components of a memory block.

Figure 6 is a magnified drawing of a portion of Figure 5 showing the components of a memory block.

Figure 7A shows an alternate embodiment of the invention.

5

Figure 7B shows an alternate way to interconnect the memory blocks in the alternate embodiment.

### Detailed Description of the Invention

Figure 3 is an actual size drawing of the preferred embodiment of the invention. The memory cells are fabricated on a 6" wafer 14 as independently functioning memory blocks 12 one hundred times smaller than dynamic RAM chips. As a result, as long as the dominant defects are point defects, a process with a yield of 5% for dynamic RAM chips; will have a yield of 97% for small memory blocks 12.

The memory blocks 12 are organized as blocks roughly 1 mm$^2$ in size and containing 2048 bytes each. The memory blocks 12 are constructed with the same technology used to construct dynamic RAMs.

The whole wafer 14, packaged in one container, provides approximately thirty megabytes of dynamic memory when 34 sq. um storage cells are used. By placing the thirty megabytes into one package, excessive packaging and handling costs are avoided. Alternatively, the wafer 14 may be diced into groups of memory blocks 12. These groups of memory blocks 12 can be individually packaged to provide smaller capacity memory devices.

The memory blocks 12 are identical and can be freely substituted for one another. Because of the interconnection scheme shown in Figure 1B, malfunctioning memory blocks 12

6

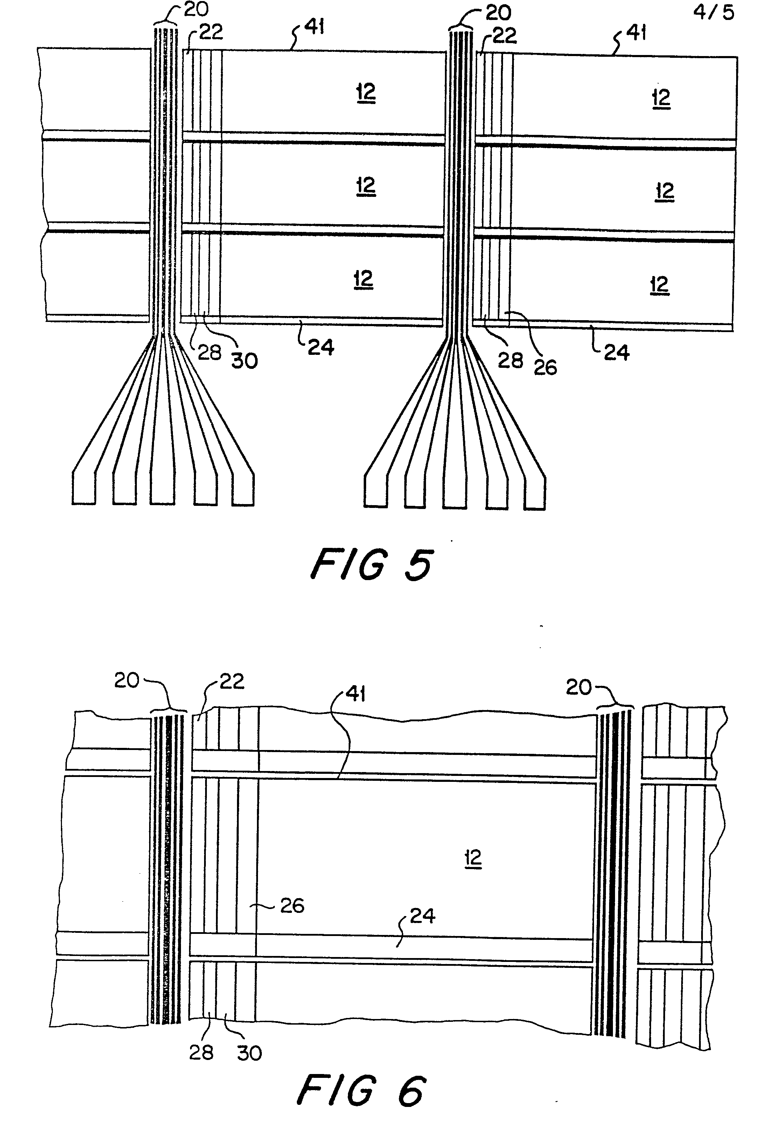

do not affect the performance of good memory blocks 12. The malfunctioning memory blocks 12 can be avoided by the controller when the memory is formatted (just like bad sectors on a disk drive are skipped). If the malfunctioning memory block 12 affects other memory blocks 12 by shorting the address and data, clock, or power lines 20, a laser can be used to blow the fuse 22 as shown in Figures 5 and 6, and thereby disconnect the malfunctioning memory block 12.

Figure 4 shows a portion of the solid state disk magnified four times. The memory blocks 12 are all identical and connect to the address and data, clock, and power lines 20. Figure 5 shows a portion of Figure 4 magnified eight times. Six identical memory blocks 12 are shown connected to the buses 20. The MBCC 41 consists of memory block control circuitry (MBCC) 41 shown in Figure 2C, 5 and 6. Each memory block 12 has its own decoding circuitry 24, amplifiers 26, control logic 28, and drivers 30. Figure 6 shows one memory block 12 and the MBCC 41.

Each memory device 14 contains a memory device control circuit (MDCC) 42 as described above and as shown in Figures 2C and 3. The MDCC 42 is manufactured on a separate chip using CMOS technology. This is the standard CMOS technology commonly practiced in the manufacture of Custom Integrated Circuits. After the MDCC 42 is manufactured and tested, it is bonded to the memory device 14 and connected via wire bonds.

7

The information is accessed by block rather than by individual bits, and is transferred to and from the memory block 12 as serial data in order to greatly reduce the number of interconnects. Many memory blocks 12 are connected to a single group of 5 lines: two ground, one power, one clock, and one address/data/control lines 20 as shown in Figures 5 and 6.

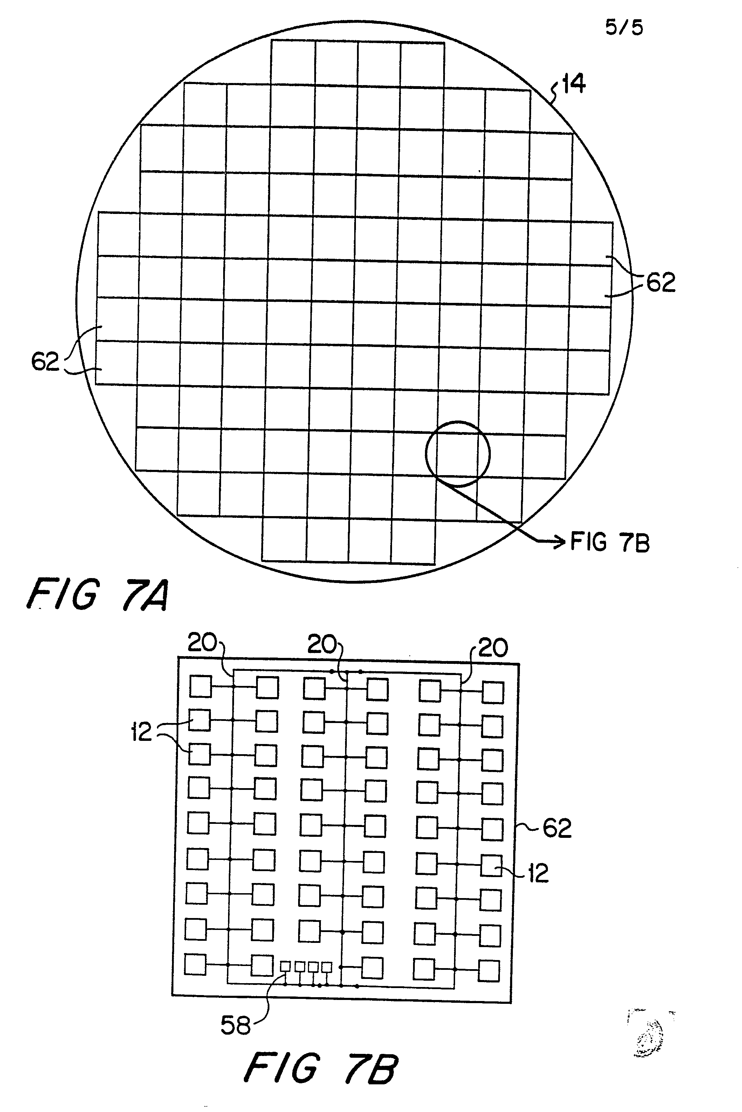

In the preferred embodiment, the lines 20 form a straight columns running from a line through the center of the memory device 14 to the perimeter of the wafer 14. The pads 60 of the memory device 14 are located along this line through the center. In an alternate embodiment of the invention shown in Figure 7A, the memory device 14 is divided into sections 62. Figure 7B shows an enlargement of a memory device section 62. The ground power, clock, and address/data/control lines 20 are arranged into three columns with memory blocks 12 connected to both sides of the columns 2. The contact pads 58 are shown in Figure 7B. Each group of 5 lines connects directly to the MDCC, so that a defect in one group does not affect the function of any other group.

Semiconductor memory, organized and accessed in blocks, rather than one bit or byte at a time, could be used in computer systems having to replace magnetic storage or can be combined with magnetic storage to provide faster access to data. Users configure RAM as a disk to obtain greater

8

memory speed for executing disk limited tasks such as compiling Pascal on a workstation, running models and simulations, or drawing and moving objects on the screen for CAD/CAM applications. A block access semiconductor memory would provide similar speed advantages, but at a lower cost than would standard DRAM. Block access semiconductor memory can also be used as a file system and/or disk cache for large and small computer systems. The addition of a level that is between RAM and mechanical disks in terms of cost and access time could greatly improve the memory system access time and throughput. Another use for a block access memory would be as mass storage for a portable computer. When fabricated with static RAM cells rather than dynamic RAM cells, a block access memory would have the same cost, 1/4 the capacity and much lower standby power. Because of its lower standby power, it could be made non-volatile with a small battery.

A block memory can also be configured as a disk and used to replace magnetic disks. Solid state disks may have specialized applications. One would be as a dedicating paging disk for Unix systems. Another might be in a workstation that would have no other disk; but would be connected to a large central disk through a network. A solid state disk would accelerate performance and reduce traffic on the network.

9

Claims

1. A memory device, c h a r a c t e r i z e d  by
a multiplicity of memory blocks (12); and
a multiplicity of first means (41), one dedicated
to one memory block (12) for controlling said
memory block (12) independently of other said
memory blocks (12).

2. A memory device as in claim 1 c h a r a c t e r i z-
e d  by
a second means (42) for controlling a plurality
of said first means (41), said second means
being electrically connected to said first means
(41), preferrably by a communication means (20).

3. A memory device as in claim 1, c h a r a c t e-
r i z e d  in that said memory blocks (12) and
said first means (41) are located on a first
substrate, e.g. a semiconductive wafer, and
said second means (42) is located on a second
substrate.

4. A memory device as in claim 3, c h a r a c t e-
r i z e d  in that said second substrate is
bonded to said first substrate or vice versa.

5. A memory device as in claim 3, c h a r a c t e-
r i z e d  in that said first substrate is diced
into a multiplicity of chips.

6. A memory device as in claim 5, c h a r a c t e-
r i z e d  in that said chips are bonded to
said second substrate.

7. A memory device as in of of claims 2 to 6,
c h a r a c t e r i z e d  in that said second
means (42) is a replaceable, tested circuit.

- 10 -

8. A memory device as in one of claims 2 to 7, c h a r a c t e r i z e d in that said communication means (20) connects said second means (42) directly to each said first means (41).

9. A memory device as in one of claims 2 to 8, c h a r a c t e r i z e d in that said communication means (20) transmits information in parallel.

10. A memory device as in one of claims 2 to 9, c h a r a c t e r i z e d by a third means to selectively connect said first means (41) to said communication means (20).

11. A memory device as in claim 10, c h a r a c- t e r i z e d in that said third means further comprises laser-blowable fuses located in said memory blocks.

12. A memory device as in one of claims 2 to 11, c h a r a c t e r i z e d in that said communica- tion means (20) further comprises a line for transmitting addresses.

13. A memory device as in one of claims 2 to 12, c h a r a c t e r i z e d in that said communica- tion means (20) further comprises a line for transmitting both addresses and data.

14. A memory device as in one of claims 2 to 7, c h a r a c t e r i z e d in that said communic- tion means (20) electrically connects to a plurality of first means (41) located in a row.

15. A memory device as in one of claims 2 to 7, c h a r a c t e r i z e d in that said communica- tion means (20) electrically connects to a plurality

- 11 -

of first means (41) located in a group having
a multiplicity of rows and columns.

16. A memory device as in one of claims 1 to 15,
c h a r a c t e r i z e d  in that the area
of each said memory blocks (12) is significantly
smaller than the reciprocal of the defect density.

**FIG 1A** (PRIOR ART)

**FIG 1B**

**FIG 2A** (PRIOR ART)

**FIG 2B** (PRIOR ART)

**FIG 2C**

FIG 3

FIG 4

FIG 5

FIG 6

FIG 7A

FIG 7B